(19) Europäisches Patentamt
European Patent Office
Office européen des brevets

(11) **EP 1 947 214 A2**

(12) **EUROPEAN PATENT APPLICATION**

(43) Date of publication:
**23.07.2008 Bulletin 2008/30**

(51) Int Cl.:
*C23C 18/14* (2006.01)    *C23C 20/06* (2006.01)
*H01L 31/18* (2006.01)

(21) Application number: **07018074.0**

(22) Date of filing: **14.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **29.09.2006 JP 2006268908**

(71) Applicant: **DOWA Electronics Materials Co., Ltd.**
**Chiyoda-ku**
**Tokyo 101-0021 (JP)**

(72) Inventors:
• **Hinotsu, Takashi**
  **Chiyoda-ku**
  **Tokyo 101-0021 (JP)**
• **Tanoue, Koji**
  **Chiyoda-ku**
  **Tokyo 101-0021 (JP)**

(74) Representative: **Samson & Partner**
**Widenmayerstrasse 5**
**80538 München (DE)**

(54) **Transparent conducting film and manufacturing method thereof**

(57)    After fluid material containing transparent conducting fine particles is coated on a substrate to form a coating film, and the transparent conducting fine particles are sintered by irradiating an electromagnetic wave after pressure is added to this coating film. For example, the pressure is added to the coating film so that density of the coating film becomes 3.0 g/cm$^3$ or more. Besides, for example, the pressure is added to a surface of the coating film by means of a roll press. Besides, for example, a line pressure of the roll press is set to be 200 kg/cm or more. Besides, for example, the irradiated electromagnetic wave is a microwave of 1 GHz to 1 THz.

**FIG.1**

START OF MANUFACTURING TRANSPARENT CONDUCTING FILM — STEP0

PREPARE FLUID MATERIAL CONTAINING TRANSPARENT CONDUCTING FINE PARTICLES — STEP1

FORM COATING FILM BY COATING PREPARED FLUID MATERIAL ON SUBSTRATE — STEP2

DRY COATING FILM — STEP3

ADD PRESSURE TO COATING FILM — STEP4

FORM TRANSPARENT CONDUCTING FILM BY IRRADIATING ELECTROMAGNETIC WAVE TO COATING FILM — STEP5

END OF MANUFACTURING TRANSPARENT CONDUCTING FILM — STEP6

EP 1 947 214 A2

**Description**

Background of the Invention

1. Field of the Invention

The present invention relates to a transparent conducting film containing transparent conducting fine particles and a manufacturing method of the transparent conducting film manufacturing the transparent conducting film by coating fluid material containing the transparent conducting fine particles on a substrate.

2. Description of the Related Art

ITO (indium oxide containing tin), $SnO_2$ (tin oxide), IZO (indium oxide containing zinc), and so on have good visible light transmittance and visual transparency, and show high electric conductivity, and therefore, they are used for transparent conducting films such as a liquid crystal display, touch panel, sensor, solar battery, organic/inorganic EL, and electronic paper.

These transparent conducting films can be manufactured by a physical method such as a spattering method, but there is demerits in this manufacturing method in which a manufacturing equipment and manufacturing cost become expensive. On the contrary, it is possible to manufacture the transparent conducting film at a low price by a method in which fine particle dispersion liquid dispersing the transparent conducting fine particles such as ITO, $SnO_2$, IZO into a solvent and so on is coated on a substrate such as a glass and polymer film, and therefore, a film formation by this manufacturing method is desired.

However, in the transparent conducting film manufactured by coating the dispersion liquid on the substrate, resistance becomes high compared to the transparent conducting film manufactured by using the physical method such as the spattering method. As a result thereof, it can be cited that particle interfaces increase because the transparent conducting film is formed by the fine particles. Besides, a surface active agent adhered on a particle surface to enhance a dispersibility becomes a factor to increase the resistance.

The surface active agent adhered on the particle surface is dissolved by burning in high temperature and the fine particles are sintered to decrease the resistance of the transparent conducting film. However, a coating film obtained by coating the transparent conducting fine particles on the polymer film cannot be burned in high temperature resulting from a characteristic of the film, and therefore, it is not possible to bring the sintering between the fine particles.

A sintering between particles is performed by irradiating a microwave to a coating film of transparent conducting fine particles in a manufacturing art of a transparent conducting film described in Japanese Patent Application Laid-open No. Hei 11-242916 to solve the problem as stated above. It is possible to generate heat on an object to be heated in itself directly and simultaneously and to heat the object to be heated comparatively uniformly, because only an object having a large dielectric loss is heated by using the microwave. Besides, there is a characteristic that it is possible to burn an object substance without causing a loss on a film because there is no thermal alteration of a substrate compared to a normal external heating method.

Summary of the Invention

However, the resistance of the transparent conducting film manufactured by the manufacturing art of the transparent conducting film in the above-stated Japanese Patent Application Laid-open No. Hei 11-242916 is $10^2$ Ω/□ (sheet resistance) or more, and it becomes larger compared to the resistance of $10^2$ Ω/□ to 1 Ω/□ of the transparent conducting film obtained by the physical method. Besides, a visible light transmittance is low at approximately 80%, and the visual transparency is also low. As stated above, in the manufacturing art of the above-stated Patent Document 1, it is difficult to manufacture the transparent conducting film which has low resistance, good visible light transmittance and visual transparency.

The present invention is made in consideration of the above-stated problems, and an object thereof is to enable a manufacture of a transparent conducting film having low resistance, good visible light transmittance and visual transparency compared to a conventional one, when the transparent conducting film is manufactured by coating fluid material such as dispersion liquid containing transparent conducting fine particles on a substrate.

The present inventors conduct a general study of the conventional publicly known manufacturing art of the transparent conducting film using a method in which the fluid material such as the dispersion liquid containing the transparent conducting fine particles is coated on the substrate, to manufacture a transparent conducting film having low resistance, good visible light transmittance and visual transparency. As a result, the following knowledge is obtained.

The present inventors find out that a sintering between particles of the transparent conducting fine particles is accelerated and low resistance of a coating film is achieved by irradiating a microwave after the coating film of the transparent conducting fine particles formed on the substrate is pressurized. In particular, it turned out that the low resistance of the coating film is more accelerated and the transparent conducting film with extremely low resistance can be obtained when the coating film is pressurized so that film density of the coating film becomes 3.0 g/cm$^3$ or more by using a roll press with a line pressure of 200 kg/cm or more. Besides, it is found out that the transparent conducting film, manufactured by irradiating the microwave after the coating film is pressurized as stated above, includes the high visible light transmittance and visual transparency. In particular, it was possible to make the visible light transmittance and visual transparency of the transparent conducting film extremely high values when indium oxide containing tin of which particle size is 100 nm or less is used as the transparent conducting fine particles. As an example of the transparent conducting film manufactured based on the above-stated knowledge, for example, a transparent conducting film having surface resistance of less than 10$^2$ Ω/□ and the visible light transmittance of 85% or more can be obtained.

Further, it is found out that it is possible to manufacture the transparent conducting film stably without damaging a film being a substrate when the microwave is irradiated while a conductive foamed sheet such as, for example, a metal foamed sheet is grounded to the transparent conducting fine particle film, because discharge is suppressed.

The present invention is made based on the knowledge as stated above. Namely, according to the present invention, a manufacturing method of a transparent conducting film is provided, in which fluid material containing transparent conducting fine particles is coated on a substrate to form a coating film, an electromagnetic wave is irradiated after pressure is added to the coating film, and the transparent conducting fine particles are sintered.

In the manufacturing method of the above-stated transparent conducting film, the pressure may be added to a surface of the coating film such that density of the coating film becomes 3.0 g/cm$^3$ or more.

In the manufacturing method of the above-stated transparent conducting film, the pressure may be added to the surface of the coating film by a roll press.

In the manufacturing method of the above-stated transparent conducting film, a line pressure of the roll press may be 200 kg/cm or more.

In the manufacturing method of the above-stated transparent conducting film, the electromagnetic wave may be a microwave with a frequency of 1 GHz to 1 THz.

In the manufacturing method of the above-stated transparent conducting film, a conductive foamed sheet may be spread under the coating film so as to prevent discharge when the electromagnetic wave is irradiated.

In the manufacturing method of the above-stated transparent conducting film, the irradiation of the electromagnetic wave may be performed under an inert atmosphere.

In the manufacturing method of the above-stated transparent conducting film, the transparent conducting fine particle may be indium oxide containing tin of which BET particle size is 100 nm or less.

Besides, according to the present invention, a transparent conducting film is provided, of which resistance is less than 100 Ω/□ (sheet resistance), haze is less than 2%, and total light transmittance is 85% or more after transparent conducting fine particle dispersion solvent is coated and particles are sintered.

In the above-stated transparent conducting film, the transparent conducting fine particle is indium oxide containing tin oxide, and a particle size thereof may be 100 nm or less.

According to the present invention, the coating film is formed by coating the fluid material containing the transparent conducting fine particles on the substrate, the sintering of the transparent conducting fine particles is accelerated by irradiating the electromagnetic wave after the pressure is added to the surface of the coating film, and thereby, it becomes possible to manufacture the transparent conducting film having very low resistance, superior in the visible light transmittance and visual transparency, without damaging on the substrate such as, for example, the polymer film. Accordingly, it becomes possible to manufacture the transparent conducting film having characteristics equivalent or more than the transparent conducting film manufactured by using the physical method such as the spattering method, by using the manufacturing method in which the transparent conducting film is manufactured by coating the fluid material containing the transparent conducting fine particles on the substrate at a low price.

Brief Description of the Drawings

FIG 1 is a flowchart showing a procedure of a manufacturing method of a transparent conducting film according to an embodiment of the present invention;
FIG 2 is a schematic side view of a roll press 1 used when the transparent conducting film is manufactured by using the manufacturing method according to the embodiment of the present invention;
FIG 3 is an explanatory view explaining a procedure irradiating a microwave to a coating film 2 applied on a polymer film 10 as a substrate, when the transparent conducting film is manufactured by using the manufacturing method according to the embodiment of the present invention; and
FIG 4 is a Table 1 showing results of examples.

Detailed Description of the Invention

Hereinafter, preferred embodiments of the present invention are described with reference to the drawings. Incidentally, a redundant description is avoided as for elements each having substantially the same functional constitution are respectively identified by the same reference numerals in the present specification and the drawings.

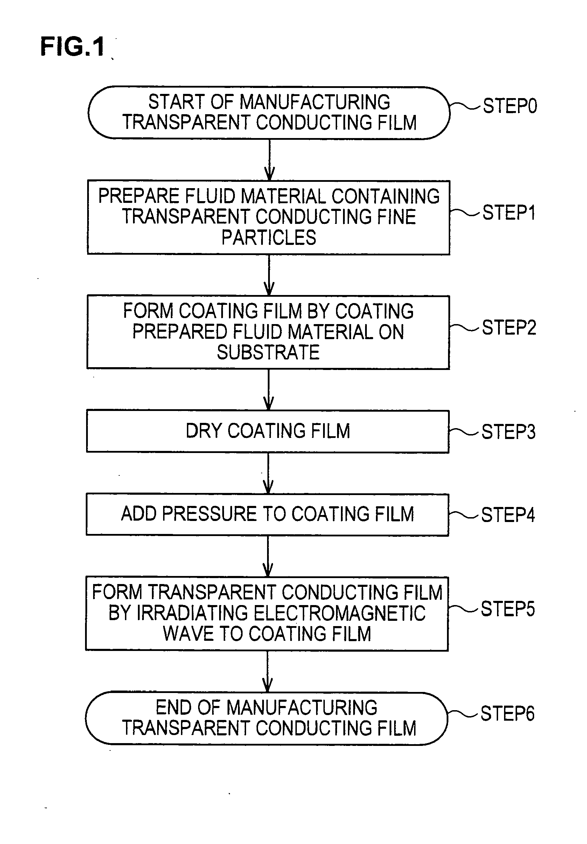

FIG 1 is a flowchart showing a procedure of a manufacturing method of a transparent conducting film according to an embodiment of the present invention. The manufacturing method of the transparent conducting film according to the embodiment of the present invention is described hereinafter by using FIG 1.

(Step 0)

A manufacture of a transparent conducting film is started.

(Step 1)

Fluid material containing transparent conducting particles is prepared. In the present embodiment, dispersion liquid as the fluid material is prepared by dispersing indium oxide containing Sn (tin) ($In_2O_3$ (called also as ITO)) into an alcoholic solvent as the transparent conducting particles. Incidentally, it is preferable that a particle size of the transparent conducting particle is 100 nm or less.

For example, $In_2O_3$ containing Zn (IZO), $In_2O_3$ containing F (FTO), $SnO_2$ containing Sb (ATO), ZnO, ZnO containing Al (AZO), ZnO containing Ga (GZO), $CdSnO_3$, $Cd_2SnO_4$, $TiO_2$, CdO, and so on may be used as the transparent conducting particles other than $In_2O_3$ containing Sn (ITO). Besides, they may be used independently, or two or more kinds may be combined arbitrary. It is preferable to use metal oxide of which main constituent is In or Sn among them to consist with conductivity and transparency.

When the transparent conducting fine particles are composed of In and Sn, it is preferable that a content of Sn is made to be 20 wt% or less. This is because resistance deteriorates caused by a scattering of a carrier if an amount of Sn included in the transparent conducting fine particles becomes large. Besides, it is more preferable that the content of Sn is from 5 wt% to 15 wt%. This is because the resistance deteriorates caused by decreased carrier density if the amount of Sn included in the transparent conducting fine particles is too small.

Besides, it is preferable that weight ratio of the transparent conducting fine particles relative to the fluid material is set to 5 wt% to 50 wt%. It is more preferable to be set to 10 wt% to 40 wt%. This is because there is a possibility that film thickness of a coating film becomes nonuniform when the fluid material is coated on the substrate at a later-described step 2 because viscosity of the fluid material becomes too small if the weight ratio of the transparent conducting fine particles relative to the fluid material is too small. Besides, if the weight ratio of the transparent conducting fine particles relative to the fluid material becomes too large, there is a possibility that a dispersion stability of the fine particles deteriorates to thereby lower the film density after the film is coated.

(Step 2)

The fluid material prepared in the above-stated step 1 is coated on the substrate. In the present embodiment, the dispersion liquid as the fluid material is coated on a polymer film as an example of a transparent substrate. As the transparent substrate, for example, cellulose triacetate, cellulose diacetate, nitrocellulose, polystyrene, polyethylene terephthalate, polyethylene naphthalate, polyimide, and so on can be used as the material. It is preferable to use polyethylene terephthalate which is superior in transparency and cheep among them.

In the present embodiment, the film coating is performed by coating the ITO dispersion liquid as the fluid material on the polymer film by using an applicator of 3 $\mu$m. As a method of coating the fluid material on the substrate, a publicly known method such as, for example, a roll coat, screen printing, spray coat, dip coat, and spin coat can be used in addition to the method using the applicator.

(Step 3)

The coating film coated on the substrate is dried. As dry temperature, it is preferable to set to a softening point or less of the polymer film used as the substrate. Concretely speaking, for example, it is preferable that the dry temperature is set at 80°C or less when polyethylene terephthalate (PET) is used as the film.

(Step 4)

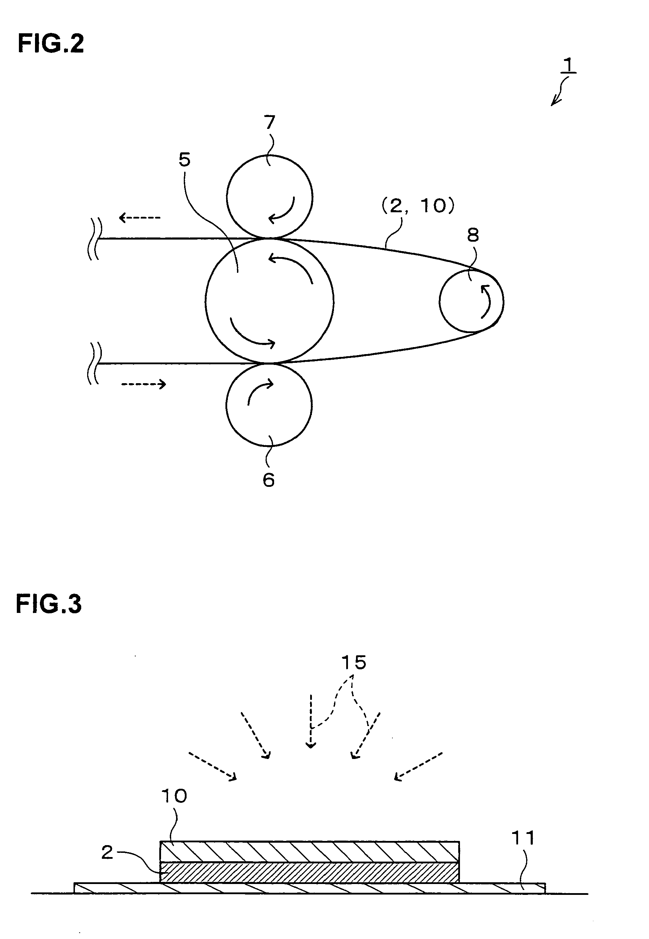

Pressure is added to the coating film. In the present embodiment, the pressure is added to a surface of a coating film 2 so that density of the coating film 2 is to be 3.0 g/cm$^3$ or more by using a roll press 1 of which schematic side view is shown in FIG. 2. As shown in FIG. 2, the roll press 1 includes a resin roll 5, two metal rolls 6, 7, and a guide roll 8 of which axial directions are disposed to be in parallel with each other (perpendicular to a page space of FIG. 2). The resin roll 5 and guide roll 8 are constituted so as to rotate, for example, in a counterclockwise direction. On the other hand, the two metal rolls 6, 7 are constituted so as to rotate, for example, in a clockwise direction under a state in which side surfaces thereof are in contact with a side surface of the resin roll 5 with each other. The roll press 1 carries a polymer film 10 as a substrate including the coating film 2 in a direction shown by dotted arrows, so that the coating film 2 can be compressed together with the polymer film 10 by being passed through while being sandwiched between the resin roll 5 and metal roll 6. Further, a traveling direction of the coating film 2 and polymer film 10 compressed by the resin roll 5 and metal roll 6 is changed via the guide roll 8, and they are passed through while being sandwiched between the resin roll 5 and metal roll 7 so that a second compression is performed.

In the present embodiment, a line pressure of the roll press 1 is set to be 200 kg/cm or more. Accordingly, the pressure is added to the coating film 2 by using the roll press 1, and it becomes possible such that the density of the coating film 2 is to be 3.0 g/cm$^3$ or more. As stated above, the roll press 1 is applied to the coating film 2, and thereby, a contact between particles becomes good and the film density increases. At the same time, a coating film surface becomes smooth, and thereby, the visible light transmittance and visual transparency of the manufactured transparent conducting film improve spectacularly. Incidentally, as a method adding the pressure to the coating film 2, a publicly known pressure means such as, for example, a sheet press may be used in addition to the method using the roll press 1 as stated above.

(Step 5)

An electromagnetic wave is irradiated to the coating film, and the transparent conducting fine particles of the coating film are sintered, to thereby form the transparent conducting film. In the present embodiment, for example, a microwave is used as the electromagnetic wave. In this case, it is possible to make the resistance after the microwave burning small if the density of the coating film is set to a large value, because the contacts between the transparent conducting fine particles with each other become frequent and the sintering is accelerated. For example, the density of the coating film is set to be 3.0 g/cm$^3$ or more to make the resistance after the microwave burning to be less than $10^2$ $\Omega/\square$ (sheet resistance).

In the present embodiment, the microwave with a frequency of 2.45 GHz is irradiated to the coating film at 1000 W for 10 minutes as the electromagnetic wave. In this case, dielectric loss of the polymer film used as the substrate is small, and therefore, an absorption does not occur even if the microwave is irradiated, and the polymer film is not heated. On the contrary, dielectric loss of the coating film of oxide applied on the polymer film is large, and therefore, the heat is generated by irradiating the microwave. It is possible to selectively heat only the coating film on the polymer film by using the above. Besides, the oxide coating film has a microwave highspeed responsiveness, and therefore, it is possible to easily control arrival time to required temperature by means of heating time and output adjustment.

In the present embodiment, the polymer film 10 on which the coating film 2 is applied is mounted on a conductive foamed sheet 11 such as, for example, a foamed Ni sheet, as shown in FIG 3, and the microwave (dotted arrows 15 in FIG 3) is irradiated to the coating film 2. At this time, the microwave is irradiated under a state in which the coating film 2 is disposed at a lower surface side of the polymer film 10, and the coating film 2 is brought into contact with the conductive foamed sheet 11. Incidentally, the microwave is irradiated from an upper surface side of the polymer film 10 (namely, an opposite side surface of the conductive foamed sheet 11). Incidentally, the irradiation of the microwave to the coating film 2 is performed under a nitride atmosphere.

(Step 6)

A manufacture of the transparent conducting film on the polymer film being the substrate is completed by the above-stated steps 1 to 5.

According to the embodiment as stated above, a coating film is formed by coating fluid material containing transparent conducting fine particles on a substrate, an electromagnetic wave is irradiated to this coating film after pressure is added, when the transparent conducting film is manufactured, and thereby, a sintering between the transparent conducting fine particles constituting the coating film can be accelerated. Consequently, it becomes possible to manufacture a transparent conducting film having lower resistance and good visible light transmittance and visual transparency compared to a transparent conducting film manufactured by a conventional publicly known manufacturing art of the transparent conducting film coating fluid material containing transparent conducting fine particles on a substrate. In particular, when the coating film is pressurized so that the film density of the coating film becomes 3.0 g/cm$^3$ or more, the low resistance is more accelerated, and it becomes possible to make the resistance very low. Accordingly, it becomes possible to manufacture the transparent conducting film having a characteristic equivalent or more than the transparent conducting film manufactured by using the physical method such as the spattering method at a low price by using the manufacturing method of the transparent conducting film according to the procedure coating the fluid material containing the transparent conducting fine particles on the substrate.

In particular, when indium oxide containing tin of which particle size is 100 nm or less is used as the transparent conducting fine particles, it becomes possible to manufacture the transparent conducting film having a very high visual transparency without generating a scattering of light inside of the coating film. Besides, the particle size is made small, and thereby, it becomes possible to fully enlarge the film density when the pressure is added to the coating film by using, for example, a roll press, the sintering between particles is appropriately accelerated when the microwave is irradiated. Accordingly, it becomes possible to further lower the resistance of the manufactured transparent conducting film.

Further, when the roll press 1 shown in FIG 2 is used to add the pressure to the coating film, it is possible to make the density of the coating film generally uniform on a whole surface by evenly adding the pressure to the whole surface of the coating film, the characteristics of the manufactured transparent conducting film becomes uniform on the whole surface, and thereby, it becomes possible to manufacture a high quality transparent conducting film. In particular, when the line pressure of the roll press 1 is set to be 200 kg/cm or more, the film density of the coating film can be made to be 3.0 g/cm$^3$ or more, and it becomes possible to manufacture the transparent conducting film having very low resistance and very high visible light transmittance compared to the case when the conventional publicly known manufacturing art is used as stated above.

Besides, the conductive foamed sheet is grounded to the transparent conducting fine particle film when the microwave is irradiated to the coating film, and thereby, it is possible to suppress discharge, and to avoid a damage such that the substrate being, for example, the polymer film and so on is melted, or the like. Further, there also is an effect to prevent a damage of the substrate because the coating film and the substrate become locally high temperature.

The preferred embodiment of the present invention is described with reference to the attached drawings hereinabove, but the present invention is not limited to the above-stated example. It is obvious that those in the art may reach various modified examples or adjusted examples within a category of a technical idea described in claims, and it should be understood that those examples also obviously belong to the technical range of the present invention.

In the above-stated embodiment, a case when the fluid material containing the transparent conducting particles is the dispersion liquid is described, but the fluid material containing the transparent conducting particles may be, for example, semi-liquid, paste, melt, solution, dispersion liquid, suspension, granular material, or the like. Besides, as a method to make the fluid material into a coating medium, methods such as a boll mill, beads mill, sand grinder, and paint shaker can be used. As a solvent to which the transparent conducting particles are mixed when the fluid material is prepared, for example, solvents such as water, alcohol, ketone, ether, and ester can be used. Besides, a surface active agent, binder, and so on may be added in some cases.

In the above-stated embodiment, a case is described when the transparent substrate to which the fluid material is coated is a polymer film in which, for example, cellulose triacetate, cellulose diacetate, nitrocellulose, polystyrene, polyethylene terephthalate, polyethylene naphthalate, polyimide, and so on are used as the material. However, the transparent substrate to which the fluid material is coated may be a polymer film of which material is other than the above, and it may be the one other than a polymer film. Besides, the substrate to which the fluid material is coated is not necessarily be transparent.

In the above-stated embodiment, a case is described when the microwave of 2.45 GHz is irradiated at 1000 W for ten minutes as the electromagnetic wave, but the frequency of the electromagnetic wave to be irradiated may be 1 GHz to 1 THz. Besides, irradiation input power of the microwave may be other values such as, for example, 500 W to 1000 W. Irradiation time of the microwave is preferable to be, for example, 1 minute to 10 minutes because it may cause a damage on the substrate resulting from the heat transmitted thereto if the irradiation time becomes long.

In the above-stated embodiment, a case is described when the foamed Ni sheet is used as the conductive foamed sheet 11. However, a sheet constituted by arbitrary material having good electronic conductivity, and heat release performance may be used as the conductive foamed sheet 11.

In the above-stated embodiment, a case is described when the irradiation of the electromagnetic wave to the coating film 2 shown in FIG. 3 is performed under the nitrogen atmosphere, but the irradiation of the electromagnetic wave may be performed in other atmospheres such as air atmosphere, inert atmosphere, or reducing atmosphere. Incidentally, when the electromagnetic wave is irradiated in the air atmosphere, there is a possibility that conductive oxide of the coating film 2 may be oxidized, carriers inside of the coating film 2 may decrease, and the resistance may deteriorate compared to the case when the microwave is irradiated under the inert atmosphere or reducing atmosphere. Accordingly, it is preferable that the irradiation of the microwave to the coating film 2 is performed in the inert atmosphere or reducing atmosphere.

Example

The present invention is described by using examples and comparative examples.

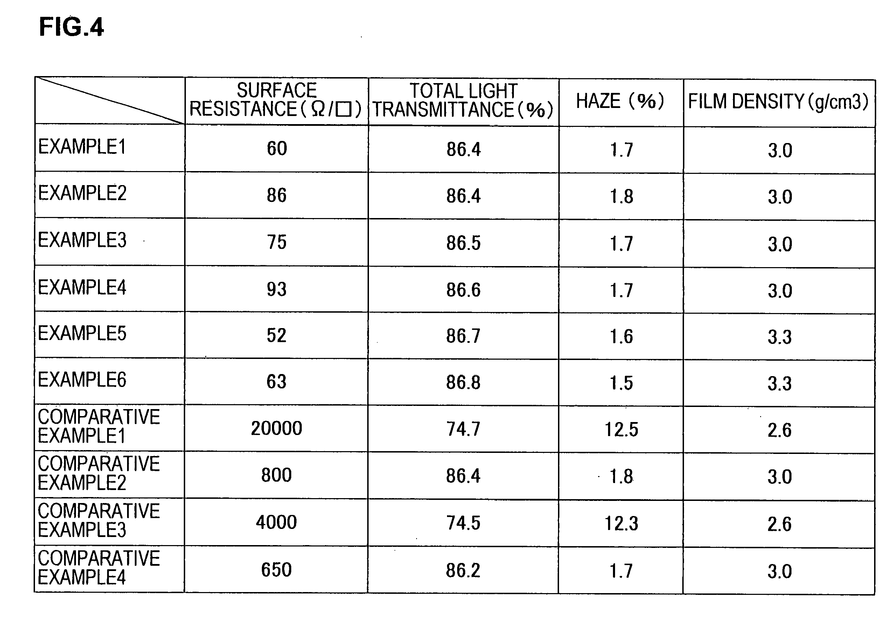

In a Table 1 shown in FIG. 4, respective data of examples 1 to 6 show respective characteristics of a transparent conducting film manufactured by using the manufacturing method of the present invention. Respective data of comparative examples 1 to 4 show respective characteristics of a transparent conducting film manufactured by using the conventional publicly known manufacturing method.

The characteristics of the respective data shown in the Table 1 are measured as stated below.

<BET particle size>

BET particle size of the transparent conducting fine particle of the transparent conducting film (coating film) is calculated by the following expression.

$$\text{BET particle size (nm)} = 6 / (\rho \times \text{specific surface area}) \times 10^9$$

However, "$\rho$" is an absolute specific gravity of the transparent conducting fine particle, and for example, when the transparent conducting fine particle is ITO (indium oxide containing tin), "$\rho = 7.13 \times 10^9$ (g/m$^3$)". Besides, the specific surface area is asked by a BET method (single point method).

<Surface Resistance>

Surface resistance of the transparent conducting film (coating film) is measured by a four-probe method by using a LorestaHP manufactured by Mitsubishi Chemical Co., Ltd..

<Total Light Transmittance and Haze>

A total light transmittance and haze of the transparent conducting film (coating film) are measured by using an NDH2000 manufactured by Nippon Denshoku Industries Co., Ltd.. A halogen lamp is used as a light source.

<Film Thickness>

Film thickness of the transparent conducting film (coating film) is observed and measured by using a scanning electron microscope of JSM-6700F manufactured by JEOL Ltd., at 10000 power magnification.

<Film Density>

Density of the transparent conducting film (coating film) is measured by the following procedure. A PET film to be the substrate is cut 5 (cm) × 5 (cm) and weight thereof is measured in advance. Subsequently, the substrate dried and pressurized after the coating of the conductive fine particles ("substrate to which the coating film is applied" in the following expression) is cut 5 (cm) × 5 (cm) and the weight is measured. Next, film thickness of the coating film is measured by using the scanning electron microscope, and the density of the film is asked based on the weights and film thickness obtained by the measurements, from the following expression. Incidentally, the substrate thickness after the roll press does not change, and the substrate weight does not also change.

$$\text{(film density)} = \{\text{(substrate weight to which the coating film is applied)} - \text{(substrate weight)}\} / \{\text{(area of coating film)} \times \text{(film thickness of coating film)}\}$$

Next, respective conditions when the transparent conducting film is manufactured are described as for the respective data (examples 1 to 6 and comparative examples 1 to 4) shown in the above-stated Table 1.

[Example 1]

The data of the example 1 show the respective characteristics of the transparent conducting film manufactured by the following procedure by using the manufacturing method of the present invention. At first, ITO powder (BET particle size of 30 nm) 7.5 g containing $SnO_2$ 15 wt% as the transparent conducting particles is mixed with alcoholic solvent 17.5 g and an anionic surface active agent 0.225 g, then they are rotated for 30 minutes at 300 rpm by a planetary ball mill (P-5 type, manufactured by Friche, container capacity of 80 ml, beads PSZ 0.3 mm), to thereby prepare dispersion liquid as the fluid material. The ITO dispersion liquid with ITO content of 30 wt% obtained as stated above is coated on a PET film (Lumirror 100T, manufactured by Toray Co., Ltd., haze of 1.5%, total light transmittance of 89%) as the substrate by an applicator (film transportation speed of 5 m/min), and it is dried at the temperature of 80°C. After that, this PET film is pressurized with the line pressure of 200 kg/cm by using the roll press (film transportation speed of 2.5 m/min) shown in FIG. 2, to thereby make the density of the coating film on the PET film to be 3.0 $g/cm^3$. A foamed Ni sheet is spread on a tray inside of a domestic microwave oven (2.45 GHz), and the manufactured transparent conducting film is disposed on this foamed Ni sheet. At this time, the film as the substrate is set while the coating film surface is to face downward so that the coating film surface of the transparent conducting film is brought into contact with the foamed Ni sheet. After that, a microwave with the frequency of 2.45 GHz is irradiated to this transparent conducting film at 1000 W for 10 minutes under a nitride atmosphere. The transparent conducting film obtained by the above-stated procedure has a surface resistance of 60 Ω/□, the total light transmittance of 86.4%, and the haze of 1.7% as shown in the data of the example 1 in the above-stated Table 1.

[Example 2]

The data of the example 2 show the respective characteristics of the transparent conducting film manufactured by a similar procedure to the case of the data of the example 1 except that the microwave irradiation is performed at 500 W.

[Example 3]

The data of the example 3 show the respective characteristics of the transparent conducting film manufactured by the similar procedure to the example 1 except that the time of the microwave irradiation is for 5 minutes.

[Example 4]

The data of the example 4 show the respective characteristics of the transparent conducting film manufactured by a similar procedure to the example 2 except that the time of the microwave irradiation is for 5 minutes.

[Example 5]

The data of the example 5 show the respective characteristics of the transparent conducting film manufactured by the similar procedure to the example 1 except that the line pressure of the roll press is set to 300 kg/cm.

[Example 6]

The data of the example 6 show the respective characteristics of the transparent conducting film manufactured by the similar procedure to the example 2 except that the line pressure of the roll press is set to 300 kg/cm.

[Comparative Example 1]

The data of the comparative example 1 show the respective characteristics of the transparent conducting film manufactured by the following procedure by using the conventional publicly known manufacturing method. Namely, the transparent conducting film of the comparative example 1 is a film in which the dispersion liquid prepared by the similar procedure to the example 1 is coated on the substrate by the applicator, and it is dried at 80°C. The film is manufactured without performing neither the roll press nor the microwave burning after that. Incidentally, the film density of this transparent conducting film is 2.6 $g/cm^3$.

[Comparative Example 2]

The data of the comparative example 2 show the respective characteristics of the transparent conducting film manufactured by the following procedure by using the conventional publicly known manufacturing method. Namely, the transparent conducting film of the comparative example 2 is manufactured by coating the dispersion liquid prepared as same as the case of the example 1 on the substrate by the applicator, drying at 80°C, and performing the roll press after that, but without performing a microwave process.

[Comparative Example 3]

The data of the comparative example 3 show the respective characteristics of the transparent conducting film manufactured by the following procedure by using the conventional publicly known manufacturing method. Namely, the transparent conducting film of the comparative example 3 is manufactured by coating the dispersion liquid prepared as same as the case of the example 1 on the substrate by the applicator, drying at 80°C, and after that, irradiating the microwave at 1000 W for 10 minutes without performing the roll press.

[Comparative Example 4]

The data of the comparative example 4 show the respective characteristics of the transparent conducting film manufactured by the following procedure by using the conventional publicly known manufacturing method. Namely, the transparent conducting film of the comparative example 4 is manufactured by coating the dispersion liquid prepared as same as the case of the example 1 on the substrate by the applicator, drying at 80°C, after that, performing the roll press, and heating at 100°C in an electric furnace under the nitride atmosphere.

As shown in the data of the examples 1 to 6 in the above-stated Table 1, in case of the transparent conducting film manufactured by using the manufacturing method of the present invention, the coating film is formed by coating the fluid material containing the transparent conducting particles on the substrate, the pressure is added to the coating film by using the roll press, and thereafter, the sintering of the transparent conducting particles is accelerated by irradiating the microwave. As a result, it can be seen that the surface resistance of less than 100 $\Omega/\square$ is realized, which is drastically lower than the values of the surface resistances of from 650 $\Omega/\square$ to 20000 $\Omega/\square$ of the transparent conducting films manufactured by using the conventional publicly known manufacturing method as shown by the data of the comparative examples 1 to 4 in the above-stated Table 1. Incidentally, as shown by the data of the comparative examples 1 and 3, it can be seen that the film density of the transparent conducting film is very small to be 2.6 (g/cm$^3$), and thereby, the surface resistance of the manufactured transparent conducting film becomes very large when the pressure is not added to the coating film at the time of manufacturing.

Incidentally, in the examples 1 to 6 of the above-stated Table 1, the burning is performed by using the foamed Ni sheet, and therefore, the discharge is prevented and the burning can be performed without damaging the film. On the contrary, when the microwave irradiation is performed without spreading the foamed Ni sheet, there is a possibility that the coating film becomes locally high temperature and disappeared caused by the discharge. Accordingly, it is preferable that a conductive foamed sheet such as the foamed Ni sheet is to be spread when the microwave irradiation is performed.

Further, as shown by the data of the examples 1 to 6 of the above-stated Table 1, the total light transmittances of the manufactured transparent conducting films become 85% or more, and these values are the same as or more than the total light transmittances of 74.7% to 86.4% of the transparent conducting films manufactured by using the conventional publicly known manufacturing method shown by the data of the comparative examples 1 to 4, and it can be seen that the transparent conducting film manufactured by the manufacturing method of the present invention is superior in the visible light transmittance. Besides, as shown by the data of the examples 1 to 6 of the above-stated Table 1, the haze of the manufactured transparent conducting films are 1.5% to 1.8%, and these values are the same as or less than the haze of the transparent conducting films of 1.7% to 12.5% manufactured by the conventional publicly known manufacturing method shown by the data of the comparative examples 1 to 4, and it can be seen that the transparent conducting film manufactured by the manufacturing method of the present invention keeps a high visual transparency.

**Claims**

1. A manufacturing method of a transparent conducting film, comprising:

   forming a coating film by coating fluid material containing transparent conducting fine particles on a substrate; and
   sintering the transparent conducting fine particles by irradiating an electromagnetic wave after pressure is added to the coating film.

2. The manufacturing method of the transparent conducting film according to claim 1,
   wherein the pressure is added to the coating film such that density of the coating film becomes 3.0 g/cm$^3$ or more.

3. The manufacturing method of the transparent conducting film according to claim 1,
   wherein the pressure is added to a surface of the coating film by means of a roll press.

4. The manufacturing method of the transparent conducting film according to claim 3,
   wherein a line pressure of the roll press is 200 kg/cm or more.

5. The manufacturing method of the transparent conducting film according to claim 1,
   wherein the electromagnetic wave is a microwave with a frequency of 1 GHz to 1 THz.

6. The manufacturing method of the transparent conducting film according to claim 1,
   wherein a conductive foamed sheet is spread under the coating film so as to prevent discharge when the electromagnetic wave is irradiated.

7. The manufacturing method of the transparent conducting film according to claim 1,
   wherein the irradiation of the electromagnetic wave is performed under an inert atmosphere.

8. The manufacturing method of the transparent conducting film according to claim 1,
   wherein the transparent conducting fine particle is indium oxide containing tin of which BET particle size is 100 nm or less.

9. A transparent conducting film in which transparent conducting fine particles are sintered after transparent conducting fine particle dispersion solvent is coated,
   wherein resistance after the sintering is less than 100 $\Omega/\square$, haze is less than 2%, and a total light transmittance is 85% or more.

10. The transparent conducting film according to claim 9,
    wherein the transparent conducting fine particle is indium oxide containing tin oxide, and a particle size thereof is 100 nm or less.

**FIG.1**

```
┌─────────────────────────────────┐
│     START OF MANUFACTURING        │──── STEP0
│  TRANSPARENT CONDUCTING FILM      │
└─────────────────────────────────┘
              │
              ▼
┌─────────────────────────────────┐
│ PREPARE FLUID MATERIAL CONTAINING │──── STEP1
│   TRANSPARENT CONDUCTING FINE      │
│            PARTICLES               │
└─────────────────────────────────┘
              │
              ▼
┌─────────────────────────────────┐
│   FORM COATING FILM BY COATING    │──── STEP2
│     PREPARED FLUID MATERIAL ON     │
│            SUBSTRATE               │
└─────────────────────────────────┘
              │
              ▼
┌─────────────────────────────────┐
│        DRY COATING FILM           │──── STEP3
└─────────────────────────────────┘
              │
              ▼
┌─────────────────────────────────┐
│    ADD PRESSURE TO COATING FILM   │──── STEP4
└─────────────────────────────────┘
              │
              ▼
┌─────────────────────────────────┐
│ FORM TRANSPARENT CONDUCTING FILM  │──── STEP5
│  BY IRRADIATING ELECTROMAGNETIC   │
│       WAVE TO COATING FILM        │
└─────────────────────────────────┘
              │
              ▼
┌─────────────────────────────────┐
│      END OF MANUFACTURING          │──── STEP6
│  TRANSPARENT CONDUCTING FILM      │
└─────────────────────────────────┘
```

**FIG.2**

**FIG.3**

# FIG.4

| | SURFACE RESISTANCE (Ω/□) | TOTAL LIGHT TRANSMITTANCE (%) | HAZE (%) | FILM DENSITY (g/cm3) |
|---|---|---|---|---|
| EXAMPLE1 | 60 | 86.4 | 1.7 | 3.0 |
| EXAMPLE2 | 86 | 86.4 | 1.8 | 3.0 |
| EXAMPLE3 | 75 | 86.5 | 1.7 | 3.0 |
| EXAMPLE4 | 93 | 86.6 | 1.7 | 3.0 |
| EXAMPLE5 | 52 | 86.7 | 1.6 | 3.3 |
| EXAMPLE6 | 63 | 86.8 | 1.5 | 3.3 |
| COMPARATIVE EXAMPLE1 | 20000 | 74.7 | 12.5 | 2.6 |
| COMPARATIVE EXAMPLE2 | 800 | 86.4 | 1.8 | 3.0 |
| COMPARATIVE EXAMPLE3 | 4000 | 74.5 | 12.3 | 2.6 |
| COMPARATIVE EXAMPLE4 | 650 | 86.2 | 1.7 | 3.0 |

EP 1 947 214 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI11242916 A